# DEMANDE DE BREVET EUROPEEN

(11) **EP 3 945 544 A1**
(43) Date de publication de la demande: **02.02.2022**
(21) Numéro de dépôt: 21188302.0
(22) Date de dépôt: 28.07.2021
(51) Int. Cl.: H01L 21/18, H01L 21/762

(54) **PROCÉDÉ D'ASSEMBLAGE DE PLAQUES PAR COLLAGE MOLÉCULAIRE**

(30) Priorité: 31.07.2020 FR 2008208
(71) Demandeur: Commissariat à l'Energie Atomique et aux Energies Alternatives, 75015 Paris (FR)
(72) Inventeur: BESSON, Pascal, 38220 NOTRE DAME DE MESAGE (FR); GUYADER, François, 38330 MONTBONNOT (FR)
(74) Mandataire: Cabinet Beaumont

(57) **Abrégé**

La présente description concerne un procédé de fabrication d'une première plaque, destinée à être assemblée à une deuxième plaque par collage moléculaire, comprenant les étapes successives suivantes :
formation d'un empilement (25) de couches (27, 29, 31, 33, 35) à la surface d'un substrat (23) ; et
gravures chimiques successives des bords desdites couches à partir de la couche de l'empilement la plus éloignée du substrat, sur une largeur de moins en moins importante.

## Description

### Domaine technique

La présente description concerne de façon générale un procédé d'assemblage de deux plaques par collage moléculaire, également appelé collage direct.

### Technique antérieure

Un procédé de fabrication d'un dispositif électronique ou optoélectronique peut comprend la fixation l'une à l'autre de plaques semiconductrices par collage moléculaire suivie de l'amincissement ou de la découpe de l'une des plaques. Les plaques peuvent présenter des bords arrondis au niveau desquels le collage moléculaire peut ne pas se réaliser de façon convenable. Une zone de fragilité est ainsi créée sur les bords des plaques. Au cours de l'étape d'amincissement ou de découpe, le bord de l'une ou des deux plaques peut alors casser.

Pour certaines applications, il existe un besoin d'améliorer cet assemblage afin de limiter les risques de ruptures qui peuvent entraîner la présence d'éléments polluants, ce qui peut être incompatible avec les conditions de propreté requises pour l'utilisation par la suite d'équipements dédiés à la fabrication de composants électroniques.

### Résumé de l'invention

Un mode de réalisation pallie tout ou partie des inconvénients des procédés d'assemblage de deux plaques par collage moléculaire décrits précédemment.

Un mode de réalisation prévoit un procédé de fabrication d'une première plaque, destinée à être assemblée à une deuxième plaque par collage moléculaire, comprenant les étapes successives suivantes :
formation d'un empilement de couches à la surface d'un substrat ; et
gravures chimiques successives des bords desdites couches à partir de la couche de l'empilement la plus éloignée du substrat, sur une largeur de moins en moins importante.

Selon un mode de réalisation, la gravure chimique de chaque couche de l'empilement comprend l'application d'une solution de gravure seulement sur le bord à graver de ladite couche.

Selon un mode de réalisation, la distance entre les bords latéraux de deux couches successives dans l'empilement est comprise entre 30 µm et 200 µm, de préférence entre 50 µm et 100 µm.

Selon un mode de réalisation, l'étape des gravures chimiques successives des bords desdites couches est suivie par une étape de formation d'un décrochement sur le pourtour du substrat.

Selon un mode de réalisation, le décrochement est formé par gravure chimique.

Selon un mode de réalisation, au moins l'une des gravures chimiques comprend l'utilisation d'une solution de fluorure d'hydrogène.

Selon un mode de réalisation, au moins l'une des gravures chimiques comprend l'utilisation d'une solution de fluorure d'hydrogène et d'acide nitrique.

Selon un mode de réalisation, au moins l'une des gravures chimiques comprend l'utilisation d'une solution d'hydroxyde de tétraméthylammonium, d'hydroxyde de tétraéthylammonium et/ou d'ammoniac.

Selon un mode de réalisation, le décrochement est formé par abrasion mécanique.

Selon un mode de réalisation, le décrochement est formé dans le substrat sur une profondeur comprise entre 5 µm et 20 µm, de préférence entre 10 µm et 15 µm.

Un autre mode de réalisation prévoit un procédé de formation d'un dispositif optoélectronique comprenant le collage moléculaire d'une première plaque, fabriquée selon le procédé décrit ci-avant, à une deuxième plaque.

Selon un mode de réalisation, le procédé comprend, après l'étape de collage moléculaire, une étape d'amincissement de la première plaque.

Un autre mode de réalisation prévoit une première plaque destinée à être assemblée à une deuxième plaque par collage moléculaire, la première plaque comprenant un substrat et un empilement de couches à la surface du substrat, le bord de chaque couche de l'empilement étant en retrait par rapport au bord de la couche adjacente la plus proche du substrat.

Selon un mode de réalisation, au moins l'une desdites couches de l'empilement est une couche semiconductrice.

Selon un mode de réalisation, au moins l'une desdites couches de l'empilement est une couche diélectrique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, par une vue en coupe, partielle et schématique, un exemple d'assemblage de deux plaques par collage moléculaire ;
la figure 2 représente, par une vue en coupe, partielle et schématique, un mode de réalisation d'une plaque adaptée à un collage moléculaire ;
la figure 3 illustre, par une vue en coupe, partielle et schématique, une étape d'un mode de réalisation d'un procédé de fabrication de la plaque représentée en figure 2 ;
la figure 4 illustre une autre étape du procédé ;
la figure 5 représente un mode de mise en oeuvre d'une étape de gravure chimique ;
la figure 6 illustre une autre étape du procédé ;
la figure 7 illustre une autre étape du procédé ;
la figure 8 illustre une autre étape du procédé ;
la figure 9 illustre une autre étape du procédé ;
la figure 10 illustre une autre étape du procédé ; et
la figure 11 illustre une autre étape du procédé.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, l'assemblage de deux plaques par collage moléculaire n'a pas été décrit en détail.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

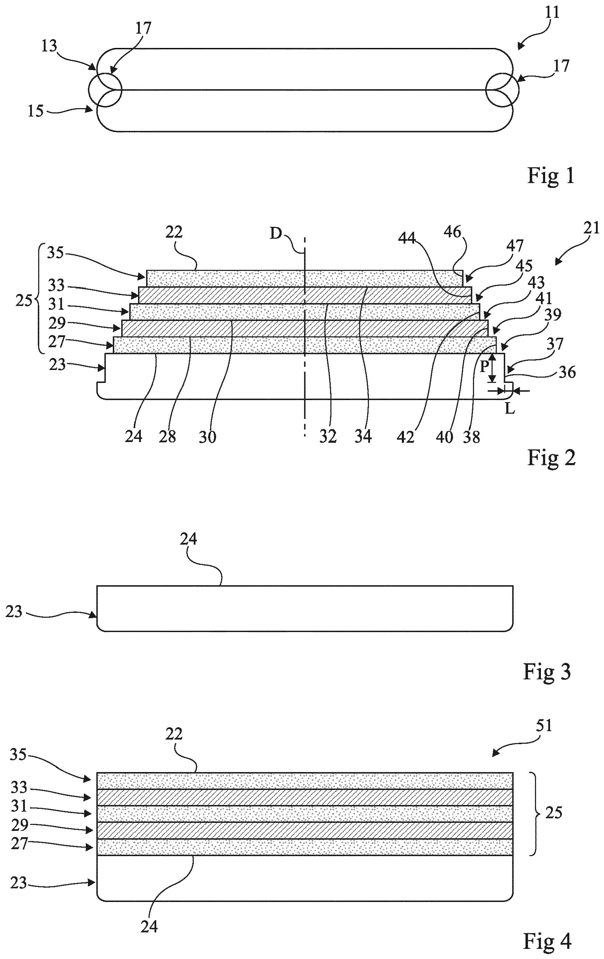

La figure 1 représente, par une vue en coupe, partielle et schématique, une structure 11 comprenant deux plaques 13, 15 assemblées l'une à l'autre par collage moléculaire. Chaque plaque 13, 15 correspond par exemple à une tranche semiconductrice adaptée à la réalisation de circuits intégrés. La structure 11 est par exemple obtenue à une étape intermédiaire d'un procédé de fabrication d'un dispositif électronique

Avant le collage moléculaire, une couche diélectrique, par exemple une couche d'oxyde de silicium, est formée sur les faces des plaques 13, 15 destinées à venir au contact l'une de l'autre lors du collage moléculaire, chacune de ces faces étant par la suite appelée face de contact. Le collage moléculaire débute lorsqu'une zone de la face de contact de la plaque 13 est mise en contact avec la face de contact de la plaque 15. Le collage se propage au reste des zones en regard des faces de contact. L'étape de collage moléculaire peut être suivie d'une étape d'amincissement de l'une des plaques 13, 15.

Chaque plaque 13, 15 comprend généralement un bord latéral dont les arêtes sont arrondies. Compte tenu de cette géométrie, le collage moléculaire entre les deux plaques 13, 15 peut ne pas se réaliser correctement à la périphérie des plaques 13, 15. La structure 11 comprend alors une zone 17 présente sur l'ensemble de la périphérie de la structure 11, au sein de laquelle les deux plaques 13 et 15 ne sont pas collées. La zone 17 s'étend depuis le bord latéral des plaques 13 et 15, en direction du centre des plaques, sur une distance de l'ordre de plusieurs centaines de micromètres, de l'ordre du millimètre, voire de l'ordre de plusieurs millimètres.

La zone 17 est une zone fragile mécaniquement dont des morceaux peuvent se briser lorsque l'une des plaques 13, 15 est soumise à une action mécanique comme une planarisation ou une découpe. Ces morceaux constituent des polluants qui peuvent perturber les étapes ultérieures du procédé de fabrication du dispositif électronique.

Il est connu de former un décrochement sur le pourtour de la face de contact de l'une des plaques 13, 15. De ce fait, la face de contact de la plaque comprenant le décrochement est collée convenablement à la face de contact de l'autre plaque et la zone fragile mécaniquement décrite précédemment est absente. Toutefois, la plaque comprenant le décrochement peut comprendre un empilement de couches, dont des couches semiconductrices, du côté de la face de contact, ces couches semiconductrices pouvant être utilisées par la suite pour la formation de composants électroniques. La formation du décrochement par sciage ou meulage peut entraîner l'incorporation d'éléments polluants dans les couches semiconductrices, les polluant provenant notamment du contact de ces couches semiconductrices avec la meule ou la scie, ce qui n'est pas souhaitable.

La figure 2 est une vue en coupe, partielle et schématique, d'un mode de réalisation d'une plaque 21 adaptée à être fixée à une autre plaque par collage moléculaire, et qui permet d'obtenir une structure collée ne comprenant pas de zone périphérique fragile.

Selon le mode de réalisation illustré en figure 2, la plaque 21 a une face de contact 22 destinée à être fixée à une autre plaque par collage moléculaire. La plaque 21 comprend un substrat 23 ayant une face supérieure 24 sur laquelle un empilement 25 de couches a été formé. L'empilement 25 comprend, de bas en haut, dans l'orientation de la figure 2 :
une couche diélectrique 27, sur et en contact avec la face supérieure 24 du substrat 23 ;
une couche semiconductrice 29, sur et en contact avec la face supérieure 28 de la couche diélectrique 27 ;
une couche diélectrique 31, sur et en contact avec la face supérieure 30 de la couche semiconductrice 29 ;
une couche semiconductrice 33, sur et en contact avec la face supérieure 32 de la couche diélectrique 31 ; et
une couche diélectrique 35, sur et en contact avec la face supérieure 34 de la couche semiconductrice 33, la couche diélectrique 35 délimitant la face de contact 22 de la plaque 21.

Selon le mode de réalisation illustré en figure 2, le substrat 23 a, de préférence, une épaisseur comprise entre 600 µm et 800 µm, par exemple de l'ordre de 775 µm. De préférence, la face supérieure 24 du substrat 23 est plane. De préférence, le substrat 23 est sensiblement à symétrie de révolution autour d'un axe D, la face supérieure 24 correspondant alors sensiblement à un disque. Le substrat 23 peut être en un matériau semiconducteur, par exemple en silicium.

Selon le mode de réalisation illustré en figure 2, le substrat 23 comprend un décrochement 37 s'étendant depuis la face supérieure 24 sur l'ensemble de la périphérie du substrat 23 sur une profondeur P et une largeur L, la profondeur P étant mesurée selon l'axe D et la largeur L étant mesurée radialement par rapport au centre de la face 24. La profondeur P du décrochement 37 est, de préférence, comprise entre 5 µm et 20 µm, par exemple, entre 10 µm et 15 µm. La largeur L est, par exemple, comprise entre 200 µm et 5 mm, de préférence, entre 1 mm et 3 mm, plus préférentiellement de l'ordre de 1,5 mm. Le décrochement 37 forme une marche à la périphérie du substrat 23.

Selon le mode de réalisation illustré en figure 2, la couche diélectrique 27 a, de préférence, une épaisseur comprise entre 20 nm et 30 nm, par exemple de l'ordre de 25 nm. La couche 27 est située sur la face supérieure 24 du substrat 23. La couche 27 recouvre la partie centrale de la face supérieure 24 de sorte que le bord latéral cylindrique 38 de la couche 27 et le bord latéral cylindrique 36 de la marche 37 du substrat 23 soient séparés par une distance, mesurée radialement par rapport à l'axe D, de 30 µm à 200 µm, de préférence de 50 µm à 200 µm, plus préférentiellement de l'ordre de 100 µm. La plaque 21 comprend alors une marche 39 entre la couche 27 et le substrat 23. La couche 27 peut être une couche de dioxyde de silicium.

Selon le mode de réalisation illustré en figure 2, la couche semiconductrice 29 a, de préférence, une épaisseur comprise entre 20 nm et 40 nm, par exemple de l'ordre de 37 nm. La couche 29 est située sur la face supérieure 28 de la couche 27. La couche 29 recouvre la partie centrale de la face supérieure 28 de sorte que le bord latéral cylindrique 40 de la couche 29 et le bord latéral cylindrique 38 de la couche 27 soient séparés par une distance, mesurée radialement par rapport à l'axe D, de 30 µm à 200 µm, de préférence de 50 µm à 100 µm, plus préférentiellement de l'ordre de 100 µm. La plaque 21 comprend alors une marche 41 entre la couche 27 et la couche 29. la couche 29 peut être une couche de silicium, formant avec le substrat 23 et la couche diélectrique 27 une structure du type silicium sur isolant (SOI, Silicon On Insulator).

Selon le mode de réalisation illustré en figure 2, la couche 31 a, de préférence, une épaisseur comprise entre 20 nm et 30 nm, par exemple de l'ordre de 25 nm. La couche 31 est située sur la face supérieure 30 de la couche 29. La couche 31 recouvre la partie centrale de la face supérieure 30 de sorte que le bord latéral cylindrique 42 de la couche 31 et le bord latéral cylindrique 40 de la couche 29 soient séparés par une distance, mesurée radialement par rapport à l'axe D, de 30 µm à 200 µm, de préférence de 50 µm à 100 µm, plus préférentiellement de l'ordre de 100 µm. La plaque 21 comprend alors une marche 43 entre la couche 29 et la couche 31. La couche 31 peut être en dioxyde de silicium et peut correspondre à un oxyde thermique.

Selon le mode de réalisation illustré en figure 2, la couche semiconductrice 33 a, de préférence, une épaisseur comprise entre 5 nm et 20 nm, par exemple de l'ordre de 15 nm. La couche 33 est située sur la face supérieure 32 de la couche 31. La couche 33 recouvre la partie centrale de la face supérieure 32 de sorte que le bord latéral cylindrique 44 de la couche 33 et le bord latéral cylindrique 42 de la couche 31 soient séparés par une distance, mesurée radialement par rapport à l'axe D, de 30 µm à 200 µm, de préférence de 50 µm à 100 µm, plus préférentiellement de l'ordre de 100 µm. La plaque 21 comprend alors une marche 45 entre la couche 31 et la couche 33. La couche 33 peut être en silicium amorphe.

Selon le mode de réalisation illustré en figure 2, La couche diélectrique 35 a, de préférence, une épaisseur comprise entre 10 nm et 30 nm, par exemple de l'ordre de 20 nm. La couche 35 est située sur la face supérieure 34 de la couche 33. La couche 35 recouvre la partie centrale de la face supérieure 34 de sorte que le bord latéral cylindrique 46 de la couche 35 et le bord latéral cylindrique 44 de la couche 33 soient séparés par une distance, mesurée radialement par rapport à l'axe D, de 30 µm à 200 µm, de préférence de 50 µm à 100 µm, plus préférentiellement de l'ordre de 100 µm. La plaque 21 comprend alors une marche 47 entre la couche 33 et la couche 35. La couche 35 peut correspondre à une couche de verre de silicium non dopé (USG, Undoped Silicon Glass).

Les marches 37, 39, 41, 43, 45 et 47 apportent une géométrie pyramidale, dite également "en escalier", à la plaque 21. Lors de l'opération de collage moléculaire, la face de contact 22 est appliquée contre la face de contact d'une autre plaque à laquelle elle se fixe par collage moléculaire. La présence des marches 37, 39, 41, 43, 45 et 47 font que la face de contact 22 est collée convenablement à la face de contact de l'autre plaque et la zone fragile mécaniquement décrite précédemment est absente. En outre, comme cela est décrit plus en détail par la suite, au moins les marches 39, 41, 42, 45, et 47 sont formées par voie chimique, sans qu'il y ait contact des couches 27, 29, 31, 33, et 35 avec un outil de sciage ou de meulage. Ainsi, une pollution des couches 27, 29, 31, 33, et 35 avec des polluants provenant du contact avec un outil de sciage ou de meulage est évitée.

La plaque 21 illustrée en figure 2 comprend un empilement 25 de cinq couches toutefois en pratique, l'empilement 25 peut comprendre un nombre de couches différent de cinq. De même, des compositions des couches et des épaisseurs des couches ont été mentionnées en relation avec la figure 2. Toutefois, en pratique, les compositions et les épaisseurs des couches peuvent être différentes.

Les figures 3 à 11 sont des vues en coupe, partielles et schématiques, de structures obtenues à des étapes successives d'un mode de réalisation d'un procédé de fabrication de la plaque 21 illustré en figure 2.

La figure 3 est une vue en coupe d'une structure de départ comprenant le substrat 23.

La figure 4 représente une structure 51 obtenue à l'issue de la formation des couches 27, 29, 31, 33 et 35 formant l'empilement 25, sur la face supérieure 24 du substrat 23. Les couches 27, 29, 31, 33 et 35 sont formées pleine plaque, c'est-à-dire que chaque couche recouvre entièrement la couche sous-jacente.

Chaque couche 27, 29, 31, 33, et 35 est par exemple déposée par dépôt chimique en phase vapeur (CVD, Chemical Vapor Deposition), notamment par dépôt chimique en phase vapeur à basse pression (LPCVD, Low-Pressure Chemical Vapor Deposition) ou par dépôt chimique en phase vapeur assisté au plasma (PECVD, Plasma-Enhanced Chemical Vapor Deposition).

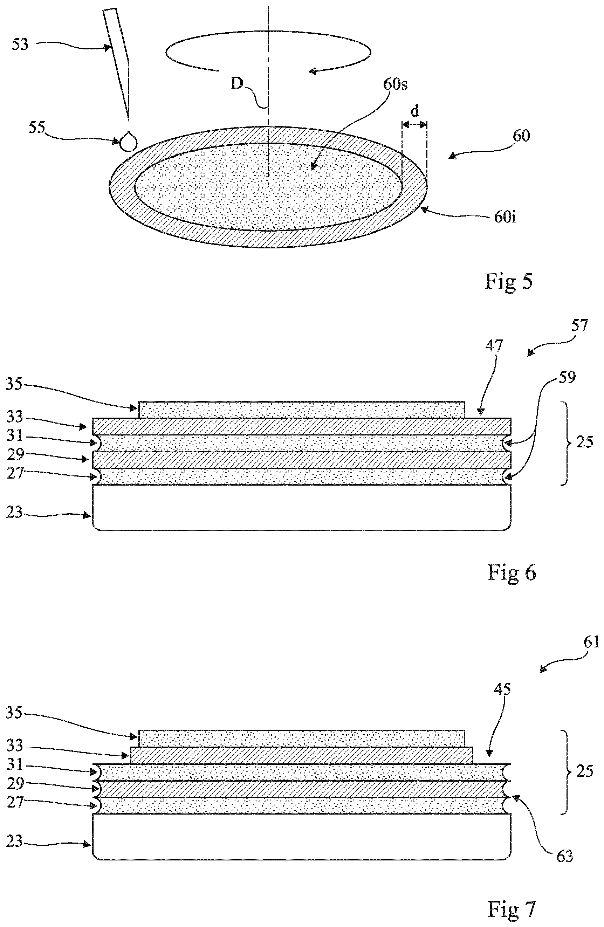

Lorsque l'ensemble des couches de l'empilement 25 ont été formées à la surface 24 du substrat 23, plusieurs étapes de gravures sont réalisées successivement afin de former les marches 37, 39, 41, 43, 45 et 47 à la périphérie des couches 23, 27, 29, 31, 33, et 35. Les structures obtenues à l'issue des étapes de gravure sont illustrées en relation avec les figures 6 à 11.

Selon un mode de réalisation, chaque marche 37, 39, 41, 43, 45 et 47 est formée par un procédé de gravure chimique tel qu'illustré en figure 5.

La figure 5 représente un mode de réalisation d'une étape de gravure chimique dans lequel la gravure est réalisée par dépôt localisé d'une solution de gravure 55 sur une plaque 60 au moyen d'une buse 53 avec un débit contrôlé, alors que la plaque 60 est en rotation autour d'un axe D. La solution de gravure 55 agit alors avec la ou les couches exposées en surface de la plaque. A titre d'exemple, le dépôt de la solution de gravure 55 entraîne la gravure d'une couche supérieure 60s afin de découvrir une couche 60i sous-jacente.

Le dépôt de la solution 55 est réalisé de façon localisée à la périphérie de la plaque 60, sur une couronne ayant une largeur d, mesurée radialement, depuis le bord latéral de la plaque 60. La largeur d peut varier en fonction de la position des couches à graver dans l'empilement 25. De préférence, plus la couche à graver est proche de la face de contact de la plaque 60, plus la distance d est élevée.

La solution 55 déposée dépend notamment de la composition de la ou des couches à graver. La solution 55 peut ainsi être, par exemple :
à base d'acide fluorhydrique (HF) lorsque la couche à graver est en oxyde de silicium ou à base d'acide fluorhydrique (HF) et de fluorure d'ammonium (NH₄F), formant une solution de type BOE ("Buffered Oxide Etch" - oxyde gravant tamponné) ;
à base d'un mélange d'acide fluorhydrique et d'acide nitrique (HNO₃) associé, par exemple, à de l'acide orthophosphorique pour former une solution de type HNP et à de l'acide sulfurique pour former une solution de type HNPS pour une gravure isotrope d'une couche en silicium ; et/ou
à base d'hydroxyde de tétraméthylammonium (TMAH), d'hydroxyde de tétraéthylammonium (TEAH), et/ou d'hydroxyde de potassium (KOH) et/ou d'ammoniaque (NH₄OH) pour une gravure anisotrope d'une couche en silicium.

La concentration des chacun des composants de la solution 55 est adaptée de sorte à obtenir la vitesse de gravure souhaitée. A titre d'exemple, la concentration massique en TMAH est comprise entre 2 % et 25 %, la concentration massique en TEAH est comprise entre 5 % et 30 %, la concentration massique en KOH est comprise entre 15 % et 40 % et la concentration massique en ammoniaque est comprise entre 15 % et 40 %.

Selon un mode de réalisation, la solution 55 est déposée à la surface de la plaque 60 avec un débit sensiblement inférieur à 100 mL/min, de préférence de l'ordre de 18 mL/min.

En figure 5, on a représenté une seule buse 53 fournissant la solution de gravure 55. A titre de variante, plusieurs buses 53 peuvent être prévues, chaque buse 53 fournissant un composant de la solution de gravure 55, le mélange de ces composants formant la solution de gravure 55. A titre de variante, chaque buse 53 permet de dispenser une solution de gravure 55 différente. La ou les buses 53 peuvent être situées sur un bras, non représenté, configuré pour déplacer les buses 53 par rapport à l'axe D de la plaque 60.

Selon un mode de réalisation, d'autres buses peuvent être prévues, par exemple pour fournir de l'eau déionisée, qui peut être utilisée comme solution de rinçage et permettre d'arrêter la gravure au moment opportun, ou pour fournir un gaz inerte comme le diazote qui peut être utilisé pour sécher la plaque après rinçage et/ou éviter les retours de phase liquide vers l'intérieur de la plaque sur sa partie externe critique.

Cette étape de gravure peut être effectuée sous atmosphère inerte, par exemple, sous diazote, notamment si les couches à graver sont sensibles aux effets de corrosion. Pour des couches de silicium ou d'oxyde de silicium, il n'est pas nécessaire que cette étape se passe sous atmosphère inerte.

Selon un autre mode de réalisation, certaines étapes de gravure (notamment les étapes de gravure des couches les plus superficielles, c'est-à-dire les couches 31, 33 et 35) comprennent chacune la formation d'un masque sur la plaque, notamment par des étapes de photolithographie, le masque recouvrant seulement la partie de la plaque ne devant pas être gravée à cette étape de gravure, le dépôt de la solution de gravure pour graver la partie de la couche supérieure de la plaque non protégée par le masque, et le retrait du masque.

La figure 6 représente une structure 57 obtenue après le retrait d'une partie périphérique de la couche 35 de l'empilement 25 de la structure 51 représentée en figure 5, sur toute la hauteur de la couche 35 de façon à former la marche 47.

Le retrait de la partie périphérique de la couche 35 peut être réalisé par le procédé décrit précédemment en relation avec la figure 5. La solution de gravure 55 utilisée pour effectuer la gravure de la partie périphérique de la couche 35 est, de préférence, à base de HF.

La gravure est réalisée sur une distance depuis le bord latéral du substrat 23 (c'est-à-dire la distance d représentée sur la figure 5) comprise entre 350 µm (5x30+200 µm) et 6 mm (5x200+5000 µm), de préférence de l'ordre de 2 mm (5x100+1500 µm).

La structure 57 peut comprendre des retraits 59 sur les bords des couches 31 et 27. En effet, la solution de gravure 55 est adaptée à la nature chimique de la couche à graver exposée sur la face supérieure de structure 51 représentée en figure 4. Toutefois, si plusieurs couches sont de même nature chimique que la couche exposée en surface, ces couches peuvent être également gravées lors de la gravure de la couche exposée en surface. Toutefois, ces couches n'étant exposées que sur une surface réduite, à savoir le bord latéral de ces couches, la gravure de ces couches reste limitée.

La figure 7 représente une structure 61 obtenue après le retrait d'une partie périphérique de la couche 33 de l'empilement 25 de la structure 57 représentée en figure 6, sur toute la hauteur de la couche 33 de façon à former la marche 45.

Le retrait de la partie périphérique de la couche 33 peut être réalisé par le procédé décrit précédemment en relation avec la figure 5. Même si une gravure isotrope est possible, on privilégiera plutôt à ce stade une gravure anisotrope qui présente une meilleure sélectivité de gravure par rapport à l'oxyde sous-jacent. La solution de gravure 55 utilisée pour effectuer la gravure de la partie périphérique de la couche 33 est, de préférence, à base de HF, de HNO₃, de HNP ou de HNPS.

La gravure est réalisée sur une distance depuis le bord latéral du substrat 23 (c'est-à-dire la distance d représentée sur la figure 5) comprise entre 320 µm (4x30+200 µm) et 5,8 mm (4x200+5000 µm), de préférence de l'ordre de 1,9 mm (4x100+1500 um).

La structure 61 peut comprendre un retrait 63 sur le bord de la couche 29. En effet, la couche 29 pouvant être de même nature chimique que la couche 33, l'étape de gravure d'une partie périphérique de la couche 33 peut aussi entraîner une gravure du bord de la couche 29.

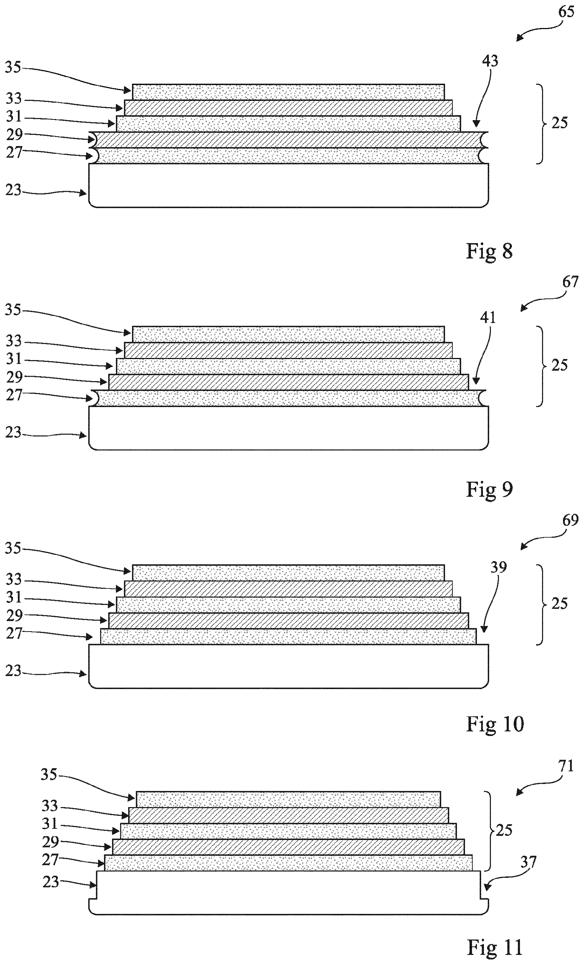

La figure 8 représente une structure 65 obtenue après le retrait d'une partie périphérique de la couche 31 de l'empilement 25 de la structure 61 représentée en figure 5, sur toute la hauteur de la couche 31 de façon à former la marche 43.

Le retrait de la partie périphérique de la couche 31 peut être réalisé par le procédé décrit précédemment en relation avec la figure 5. La solution de gravure 55 utilisée pour effectuer la gravure de la partie périphérique de la couche 31 est, de préférence, à base de HF.

La gravure est réalisée sur une distance depuis le bord latéral du substrat 23 (c'est-à-dire la distance d représentée sur la figure 5) comprise entre 290 µm (3x30+200 µm) et 5,6 mm (3x200+5000 µm), de préférence, de l'ordre de 1,8 mm (3x100+1500 µm). L'étape de gravure d'une partie périphérique de la couche 31 peut aussi entraîner une gravure du bord de la couche 27.

La figure 9 représente une structure 67 obtenue après le retrait d'une partie périphérique de la couche 29 de l'empilement 25 de la structure 65 illustrée en figure 8, sur toute la hauteur de la couche 29 de façon à former la marche 41.

Le retrait de la partie périphérique de la couche semiconductrice 29 peut être réalisé par le procédé décrit précédemment en relation avec la figure 5. Même si une gravure isotrope est possible, on privilégiera plutôt à ce stade une gravure anisotrope qui présente une meilleure sélectivité de gravure par rapport à l'oxyde sous-jacent. La solution de gravure 55 utilisée pour effectuer la gravure de la partie périphérique de la couche 29 est, de préférence, à base de HF, de HNO₃, de HNP ou de HNPS.

La gravure est réalisée sur distance depuis le bord latéral du substrat 23 (c'est-à-dire la distance d représentée sur la figure 5) comprise entre 260 µm (2x30+200 µm) et 5,4 mm (2x200+5000 µm), de préférence, de l'ordre de 1,7 mm (2x100+1500 µm).

La figure 10 représente une structure 69 obtenue après le retrait d'une partie périphérique de la couche 27 de l'empilement 25 de la structure 67 illustrée en figure 9, sur toute la hauteur de la couche 27 de façon à former la marche 39.

Le retrait de la partie périphérique de la couche 27 peut être réalisé par le procédé décrit précédemment en relation avec la figure 5. La solution de gravure 55 utilisée pour effectuer la gravure de la partie périphérique de la couche est, de préférence, à base de HF.

La gravure est réalisée sur une distance depuis le bord latéral du substrat 23 (c'est-à-dire la distance d représentée sur la figure 5) comprise entre 230 µm (30+200 µm) et 5,2 mm (200+5000 µm), de préférence, de l'ordre de 1,6 mm (100+1500 µm).

La figure 11 représente une structure 71 obtenue après la formation du décrochement 37 dans le substrat 23 de la structure 69 illustrée en figure 10.

Le décrochement 37 est, selon un mode de réalisation, réalisé par le procédé décrit précédemment en relation avec la figure 5. Même si une gravure anisotrope est possible, on privilégiera plutôt à ce stade une gravure isotrope qui présente une vitesse de gravure plus élevée et ce compte tenu de l'épaisseur importante à graver. La solution de gravure 55 utilisée pour former le décrochement 37 est, de préférence, à base de TMAH, TEAH, KOH ou NH₄OH. La gravure est réalisée sur une distance depuis le bord latéral de la face inférieure du substrat 23 (c'est-à-dire la distance d représentée en figure 5) comprise entre 200 µm et 5 mm, de préférence de l'ordre de 1,5 mm.

Selon un autre mode de réalisation, le décrochement 37 est formé par un procédé de découpe mécanique, en utilisant une scie et/ou une meule. L'utilisation d'un outil de meulage ou de sciage n'entraîne pas de contamination des couches 27, 29, 31, 33, 35 dans la mesure où l'outil de meulage ou de sciage ne vient pas en contact avec ces couches 27, 29, 31, 33, 35 en raison des marche 39, 41, 42, 45, 47.

Un avantage des modes de réalisation décrits est qu'ils permettent de s'assurer d'un bon collage entre deux plaques et ainsi réduire les risques de formation d'une zone fragile susceptible de se rompre lors d'une étape de planarisation ultérieure.

Un autre avantage des modes de réalisation décrits est qu'ils permettent de limiter la contamination métallique à la surface de l'empilement de couches. Il est alors possible de réaliser des circuits dans et sur les plaques ainsi formées.

Un autre avantage des modes de réalisation décrits est que la formation successive des marches 39, 41, 42, 45, 47 assure que le bord latéral d'aucune des couches 27, 29, 31, 33, 35 ne se trouve en porte à faux par rapport aux couches voisines, ce qui entraînerait la formation d'une zone fragile susceptible de se rompre.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de formation d'un dispositif électronique ou optoélectronique, comprenant :
la fabrication d'une première plaque (21), comprenant les étapes successives suivantes :
- formation d'un empilement (25) de couches (27, 29, 31, 33, 35) à la surface d'un substrat (23) ; et
- gravures chimiques successives des bords desdites couches à partir de la couche de l'empilement la plus éloignée du substrat, sur une largeur de moins en moins importante ; et
le collage moléculaire de la première plaque (21) à une deuxième plaque.

2. Procédé selon la revendication 1, dans lequel la gravure chimique de chaque couche (27, 29, 31, 33, 35) de l'empilement (25) comprend l'application d'une solution de gravure (55) seulement sur le bord à graver de ladite couche.

3. Procédé selon la revendication 1 ou 2, dans lequel la distance entre les bords latéraux de deux couches (27, 29, 31, 33, 35) successives dans l'empilement (25) est comprise entre 30 µm et 200 µm, de préférence entre 50 µm et 100 µm.

4. Procédé selon l'une quelconque des revendications 1 à 3, dans lequel l'étape des gravures chimiques successives des bords desdites couches (27, 29, 31, 33, 35) est suivie par une étape de formation d'un décrochement (37) sur le pourtour du substrat (23).

5. Procédé selon la revendication 4, dans lequel le décrochement (37) est formé par gravure chimique.

6. Procédé selon l'une quelconque des revendications 1 à 5, dans lequel au moins l'une des gravures chimiques comprend l'utilisation d'une solution de fluorure d'hydrogène.

7. Procédé selon l'une quelconque des revendications 1 à 6, dans lequel au moins l'une des gravures chimiques comprend l'utilisation d'une solution de fluorure d'hydrogène et d'acide nitrique.

8. Procédé selon l'une quelconque des revendications 1 à 7, dans lequel au moins l'une des gravures chimiques comprend l'utilisation d'une solution d'hydroxyde de tétraméthylammonium, d'hydroxyde de tétraéthylammonium et/ou d'ammoniac.

9. Procédé selon la revendication 4, dans lequel dans lequel le décrochement (37) est formé par abrasion mécanique.

10. Procédé selon la revendication 4, dans lequel le décrochement (27) est formé dans le substrat (23) sur une profondeur comprise entre 5 µm et 20 µm, de préférence entre 10 µm et 15 µm.

11. Procédé selon l'une quelconque des revendications 1 à 10, comprenant, après l'étape de collage moléculaire, une étape d'amincissement de la première plaque (21).

12. Assemblage comprenant :
une première plaque (21) comprenant un substrat (23) et un empilement (25) de couches (27, 29, 31, 33, 35) à la surface du substrat (23), le bord de chaque couche de l'empilement étant en retrait par rapport au bord de la couche adjacente la plus proche du substrat ; et
une deuxième plaque fixée par collage moléculaire à la première plaque.

13. Assemblage selon la revendication 12, dans lequel au moins l'une desdites couches (27, 29, 31, 33, 35) de l'empilement (25) est une couche semiconductrice (29, 33).

14. Assemblage selon la revendication 12 ou 13, dans lequel au moins l'une desdites couches (27, 29, 31, 33, 35) de l'empilement (25) est une couche diélectrique (35, 31, 27) .
